# EUROPEAN PATENT SPECIFICATION

(11) **EP 1 780 811 B1**
(45) Date of publication and mention of the grant of the patent: **05.10.2011**
(21) Application number: 05765304.0
(22) Date of filing: 01.07.2005
(51) Int. Cl.: H01L 35/32, H01L 35/20, H01L 35/30, H02N 11/00

(54) **THERMOELECTRIC CONVERSION MODULE**
THERMOELEKTRISCHES WANDLERMODUL
MODULE DE CONVERSION THERMOÉLECTRIQUE

(30) Priority: 01.07.2004 JP 2004195724
(43) Date of publication of application: 02.05.2007
(73) Proprietor: Universal Entertainment Corporation, Tokyo (JP)
(72) Inventor: TAKAHASHI, Koh, Aruze Corp., Tokyo 135-0063 (JP)
(74) Representative: Wiedemann, Peter
(86) International application number: PCT/JP2005/012244
(87) International publication number: WO 2006/004060

(56) References cited:
- JP-A- 05 283 754
- JP-A- 08 070 142
- JP-A- 09 074 228
- JP-A- 58 014 586
- JP-A- 2000 258 256
- JP-B1- 47 048 037
- JP-U- 04 028 461
- US-A- 1 076 438
- US-A- 3 054 840
- US-A- 3 496 028
- US-A- 3 522 106
- US-A- 3 759 244
- US-A- 4 638 107
- US-A- 6 096 966

## Description

### TECHNICAL FIELD

The present invention relates to a thermoelectric conversion module, and relates to a thermoelectric conversion module comprising a plurality of thermoelectric elements.

### BACKGROUND ART

Thermoelectric conversion means the mutual conversion of thermal energy to electric energy with use of the Peltier effect or the Seebeck effect. By utilizing the thermoelectric conversion, electricity is taken out from heat flow using the Seebeck effect, or electric current is applied to a material using the Peltier effect, to be able to bring about an endothermic phenomenon or an exothermic phenomenon. Also, the thermoelectric conversion is characterized by few generation of excessive waste at the time of energy conversion due to direct conversion, ability to make efficient use of exhaust heat, maintenance free due to no provision of movable parts such as a motor and a turbine, and so on, and thus attracts attention as a technique for high-efficiency use of energy.

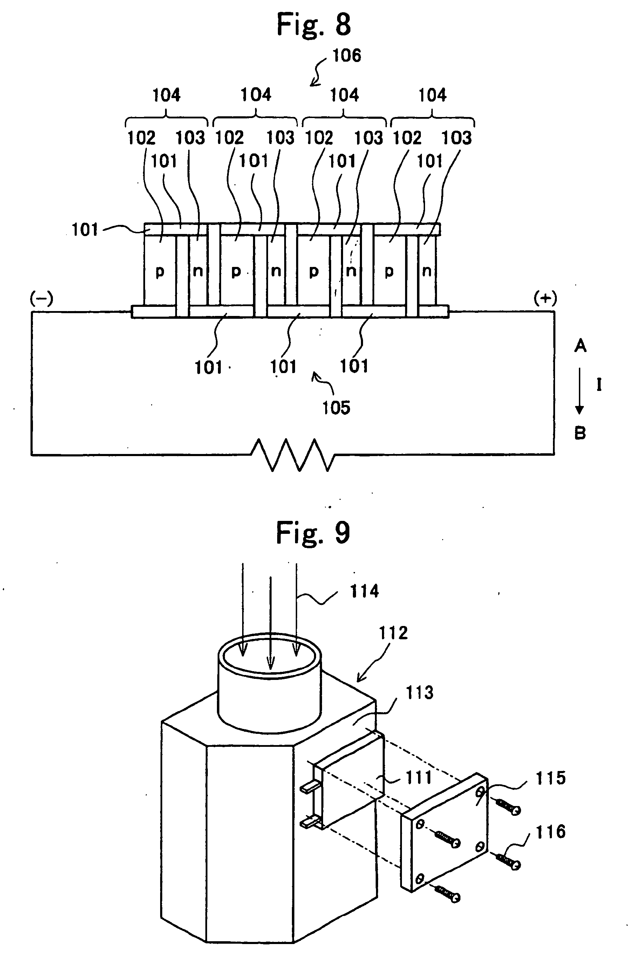

The thermoelectric conversion usually uses metal or semiconductor elements called thermoelectric elements. As shown in Fig. 8, two kinds of thermoelectric elements, a p-type thermoelectric element 102 and an n-type thermoelectric element 103, are conventionally used. When one of the two thermoelectric elements, the p-type thermoelectric element 102 and the n-type thermoelectric element 103, is heated while the other is cooled, in a state where they are electrically connected to each other by an electrode 101, this temperature difference generates voltage. To explain this in Fig. 8; when a lower portion 105 of a pi-type (π-type) element 104 that is formed in a pi-shape by connecting the p-type thermoelectric element 102 to the n-type thermoelectric element 103 is heated while an upper portion 106 is cooled, thermal energy absorbed from the lower portion 105 is converted into electric energy, and electric current flows in a direction from A to B.

However, the thermoelectric conversion by a single pi-type element cannot exert practical electricity due to insufficient energy output. Thus, in order to obtain practical electricity by the thermoelectric conversion, the thermoelectric conversion is preferably performed by integrating a plurality of pi-type elements. A unit that performs the thermoelectric conversion by integrating a plurality of thermoelectric elements to obtain practical electricity in such a manner is referred to as a thermoelectric conversion module (hereinafter abbreviated as "module").

Fig. 9 is a perspective view showing a use example of a conventional module. A conventional module 111 was in a flat-plate structure in which the aforementioned many p-type thermoelectric elements (not shown) and n-type thermoelectric elements (not shown) are linearly arranged inside, and in which the module is fixed with an electrically insulated fixing member 115. Also, since the conventional module was regarded as a separate element from a fluid channel acting as a heat source, the module 111 was attached to a flat surface 113 formed outside a cylindrical fluid channel 112 as shown in Fig. 9.

In order to obtain electric output as a result of the thermoelectric conversion in the module 111, high-temperature (or low-temperature) fluid 114 needed to flow inside the cylindrical fluid channel 112 to generate temperature difference between a surface (inner surface) that the internal portion (flat surface 113) of the module 111 contacts and a surface (outer surface) opposed to it. At this point, in order to increase the temperature difference between the inner surface and the outer surface of the module 111 as much as possible with the aim of obtaining as much output as possible, it was necessary to let the temperature of the inner surface of the module 111 as close as possible to the temperature of the fluid 114 flowing inside the cylindrical fluid channel 112. Accordingly, in order to conduct the heat of the fluid 114 to the inner surface of the module 111 as much as possible; the module 111 was covered with the fixing member 115 and was fixed with screws 116 tightly.

In such a manner, the conventional flat-plate structured module needed to be attached to the fluid channel by using the fixing member and the screws, and as a result, an electric generating system using the conventional flat-plate structured module had a complicated structure.

Thereafter, a tubular module having a simpler structure than that of the aforementioned flat-plate structured module was developed (refer to Patent Document 1).
Patent Document 1: Japanese Patent No. 2775410.

By way of further example, US-A-3,522,106 is concerned with a thermoelectric generator.

### DISCLOSURE OF THE INVENTION

### Problems to be Solved by the Invention

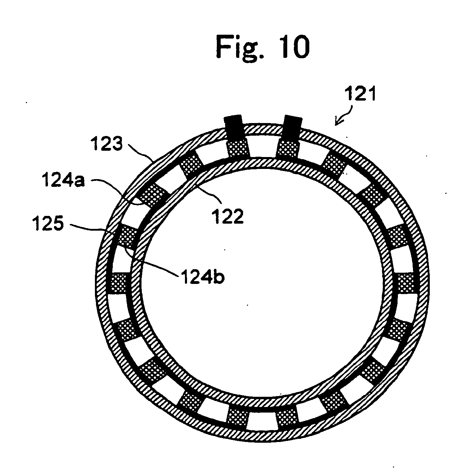

However, as shown in Fig. 10, a developed tubular module 121 had a structure in which a p-type thermoelectric element 124a and an n-type thermoelectric element 124b are arranged alternately in a rotation symmetric form between coaxial doubled cylindrical tubes consisting of an inner tube 122 and an outer tube 123, and in which the p-type thermoelectric element 124a and the n-type thermoelectric element 124b are connected alternately by an electrode 125. The conventional module completed in such a manner using the p-type thermoelectric elements and the n-type thermoelectric elements required extensive time and work in assembly since the assembly procedure was complicated, and the number of parts constituting the module was large. Thus, it eventually became a high cost product and could not be regarded as sufficiently practical.

The present invention has been made to solve the foregoing problems, and an object of the present invention is to provide a thermoelectric conversion module enabling cost reduction by reducing the number of parts, making the assembly procedure simpler, reducing time and work required for assembly, and so on.

### Means for Solving the Problems

In order to achieve the above object, the present invention provides the following.

According to a first aspect of a thermoelectric conversion module equipping: a tubular element unit in which a disk-shaped first thermoelectric element and a disk-shaped second thermoelectric element that generate electricity by temperature difference between an inner circumference surface and an outer circumference surface are layered alternately; a support unit consisting of an electrically insulated inner tube that internally touches said element unit and an electrically insulated outer tube that externally touches said element unit, characterised in that and on the inner circumference surface of said first thermoelectric element is provided a nail member that is to be connected to the inner circumference surface of said second thermoelectric element, and wherein on the outer circumference surface of said second thermoelectric element is provided a nail member that is to be connected to the outer circumference surface of said first thermoelectric element.

In accordance with the invention in the first aspect, a tubular element unit in which a first thermoelectric element and a second thermoelectric element are layered alternately and a support unit having an electrically insulated inner tube that internally touches this element unit and an electrically insulated outer tube that externally touches the element unit are provided. Thus, the thermoelectric conversion module according to the invention in (1) can be assembled more easily than a conventional thermoelectric conversion module since it has a simple structure in which the element unit is formed by layering the first thermoelectric element and the second thermoelectric element alternately, and in which this element unit is just supported by the inner tube and the outer tube.

Also, according to the first aspect of the present invention, a nail member provided on the inner circumference surface of the first thermoelectric element is connected to the inner circumference surface of the second thermoelectric element, and a nail member provided on the outer circumference surface of the second thermoelectric element is connected to the outer circumference surface of the first thermoelectric element. Thus, the thermoelectric conversion module according to the first aspect of the present invention needs only a small number of parts since it does not require an electrode that electrically connects thermoelectric elements to each other as in the conventional thermoelectric conversion module.

From the above, according to the first aspect of the present invention, it is possible to enable cost reduction by reducing time and work required for assembly, and so on since the number of parts is reduced, and the assembly procedure is simple, in comparison with the case of the conventional thermoelectric conversion module.

Meanwhile, the aforementioned element unit may be an element unit being in a substantially tubular shape formed by layering a disk-shaped first thermoelectric element having a center hole opened and a disk-shaped second thermoelectric element having approximately the same shape and having a center hole opened alternately with a predetermined space there between, wherein said first thermoelectric element includes at least one first nail member protruded from its disk surface in the vicinity of the rim of the center hole and includes at least one first cutout in the vicinity of the outer circumference of its disk shape, and said second thermoelectric element includes at least one second nail member protruded from its disk surface in the vicinity of the outer circumference of its disk shape and includes at least one second cutout in the vicinity of the rim of the center hole, wherein said first nail member is engaged with said second cutout, and said second nail member is engaged with said first cutout with said predetermined space maintained there between, and wherein a tube whose outer circumference surface has been insulated is engaged with the center hole of said element unit, and a tube whose inner circumference surface has been insulated is engaged with the outer circumference surface of said element unit.

According to a second aspect of the thermoelectric conversion module as described in the first aspect of the present invention, wherein on the outer circumference surface of said first thermoelectric element is provided a receiving portion to which said nail member of said second thermoelectric element is to be connected, and wherein on the inner circumference surface of said second thermoelectric element is provided a receiving portion to which said nail member of said first thermoelectric element is to be connected.

According to the second aspect of the present invention, a receiving portion provided on the outer circumference surface of the first thermoelectric element is connected to the nail member of the second thermoelectric element, and a receiving portion provided on the inner circumference surface of the second thermoelectric element is connected to the nail member of the first thermoelectric element. Thus, the thermoelectric conversion module according to the second aspect of the present invention needs only a small number of parts since it do not require an electrode that electrically connects thermoelectric elements to each other as in the conventional thermoelectric conversion module.

According to a third aspect of the thermoelectric conversion module according to the second aspect of the present invention, wherein said nail member is engaged with said receiving portion.

According to the third aspect of the present invention, the first thermoelectric element is connected to the second thermoelectric element as a result of the engagement of the nail member with the receiving portion. Thus, the thermoelectric conversion module according to the third aspect of the present invention needs only a small number of parts since it do not require an electrode that electrically connects thermoelectric elements to each other as in the conventional thermoelectric conversion module.

According to a fourth aspect of the thermoelectric conversion module according to the second aspect of the present invention, wherein said nail member is welded to said receiving portion.

According to the fourth aspect of the present invention, the first thermoelectric element is connected to the second thermoelectric element as a result of the welding of the nail member to the receiving portion. Thus, the thermoelectric conversion module according to the forth aspect of the present invention needs only a small number of parts since it does not require an electrode that electrically connects thermoelectric elements to each other as in the conventional thermoelectric conversion module.

According to a fifth aspect of the thermoelectric conversion module according to any one of the first to fourth aspects of the present invention, wherein said first thermoelectric element is made of a silicon-aluminum-manganese-nickel alloy, and wherein said second thermoelectric element is made of a nickel alloy selected from a group consisting of a chromium-nickel alloy and a chromium-iron-nickel alloy.

According to a sixth aspect of the thermoelectric conversion module according to any one of the first to fourth aspects of the present invention, wherein said second thermoelectric element is made of a silicon-aluminum-manganese-nickel alloy, and wherein said first thermoelectric element is made of a nickel alloy selected from a group consisting of a chromium-nickel alloy and a chromium-iron-nickel alloy.

Conventionally, a heavy-metal bismuth-tellurium alloy having high thermoelectric conversion efficiency (hereinafter referred to as "BiTe alloy") was a major material used for a thermoelectric element, but a thermoelectric element made of the BiTe alloy not only had a problem in the environmental aspect but also had a problem of higher manufacturing cost than a thermoelectric element made of a semiconductor since it uses Bi and Te that are heavy metals and also rare metals. Also, in the manufacturing aspect as well, the BiTe alloy was easy to break, had a problem in mechanical strength, and had poor processability as a weak bonding part occurs in the process of crystal growth. Further, thermoelectric conversion modules are being used under a high temperature such as in an incinerator for industrial waste more frequently, but since the BiTe alloy lacks in stability under a high temperature, the thermoelectric element made of the BiTe alloy could not be used under a high temperature.

According to the fifth and sixth aspects of the present invention, when the first thermoelectric element is made of a silicon-aluminum-manganese-nickel alloy, the second thermoelectric element is made of a nickel alloy selected from a group consisting of a chromium-nickel alloy and a chromium-iron-nickel alloy, and on the contrary, when the first thermoelectric element is made of a nickel alloy selected from a group consisting of a chromium-nickel alloy and a chromium-iron-nickel alloy, the second thermoelectric element is made of a silicon-aluminum-manganese-nickel alloy. Here, the nickel alloy is more reasonable than the BiTe alloy, and a thermoelectric element made of the nickel alloy has no inferior thermoelectric conversion performance to that of a thermoelectric element made of the BiTe alloy. Thus, according to the fifth and sixth aspects of the present invention, the manufacturing cost of the thermoelectric conversion module can without degrading the thermoelectric conversion performance, in comparison with that of a conventional thermoelectric conversion module using the thermoelectric elements made of the BiTe alloys. Further, since the nickel alloys have superior mechanical strength and stability under a high temperature to those of the BiTe alloys, it is possible to provide a thermoelectric conversion module that has greater processability and provide more stable use under a high temperature than the thermoelectric conversion module using the thermoelectric elements made of the BiTe alloys does.

According to the present invention, a tubular element unit in which a first thermoelectric element and a second thermoelectric element are layered alternately and a support unit consisting of an electrically insulated inner tube that internally touches this element unit and an electrically insulated outer tube that externally touches the element unit are provided. Thus, the thermoelectric conversion module according to the present invention can be assembled more easily than a conventional thermoelectric conversion module since it has a simple structure in which the element unit is formed by layering the first thermoelectric element and the second thermoelectric element alternately, and in which this element unit is just supported by the inner tube and the outer tube.

Also, a nail member provided on the inner circumference surface of the first thermoelectric element is connected to the inner circumference surface of the second thermoelectric element, and a nail member provided on the outer circumference surface of the second thermoelectric element is connected to the outer circumference surface of the first thermoelectric element. Thus, the thermoelectric conversion module according to the present invention needs only a small number of parts since it do not require an electrode that electrically connects thermoelectric elements to each other as in the conventional thermoelectric conversion module.

From the above, according to the present invention, it is possible to enable cost reduction by reducing time and work required for assembly, and so on since the number of parts is reduced, and the assembly procedure is simple, in comparison with the case of the conventional thermoelectric conversion module.

### BRIEF DESCRIPTION OF THE DRAWINGS

Fig. 1 is a perspective view showing a thermoelectric conversion module.
Fig. 2 is a cross-sectional view along the A-B line in the longitudinal direction of the thermoelectric conversion module in Fig. 1.
Fig. 3A is a perspective view of a first thermoelectric element constituting the thermoelectric conversion module.
Fig. 3B is a side view of the first thermoelectric element constituting the thermoelectric conversion module.
Fig. 4A is a perspective view of a second thermoelectric element constituting the thermoelectric conversion module.
Fig. 4B is a side view of the second thermoelectric element constituting the thermoelectric conversion module.
Fig. 5A is a cross-sectional view of the first thermoelectric element and the second thermoelectric element constituting the thermoelectric conversion module.
Fig. 5B is a cross-sectional view of a ring-shaped pi-type element formed after the first thermoelectric element has been connected to the second thermoelectric element.
Fig. 5C is a cross-sectional view before the two ring-shaped pi-type elements are connected to each other.
Fig. 5D is a cross-sectional view of the two ring-shaped pi-type elements after they have been connected.
Fig. 6A is a front view of a first nickel alloy plate constituting the thermoelectric conversion module.
Fig. 6B is a front view of a second nickel alloy plate.
Fig. 7 is a cross-sectional view of an element unit constituting the thermoelectric conversion module.
Fig. 8 is a fundamental view showing an example of a conventional thermoelectric conversion module.
Fig. 9 is a perspective view showing a use example of the conventional thermoelectric conversion module.
Fig. 10 is a horizontal cross-sectional view showing an example of a conventional thermoelectric conversion module.

### Description of the Numerals

10 thermoelectric conversion module
21 element unit
22 first thermoelectric element
22A outer circumference surface
22B inner circumference surface
24a, 24b, 24c, 24d nail member
25a, 25b, 25c, 25d cutout
26 second thermoelectric element
26A outer circumference surface
26B inner circumference surface
28a, 28b, 28c, 28d nail member
29a, 29b, 29c, 29d cutout
41 support unit
42, 43 SUS tube

### PREFERRED MODE FOR CARRYING OUT THE INVENTION

Hereinafter, an embodiment of the present invention will be described with reference to the drawings.

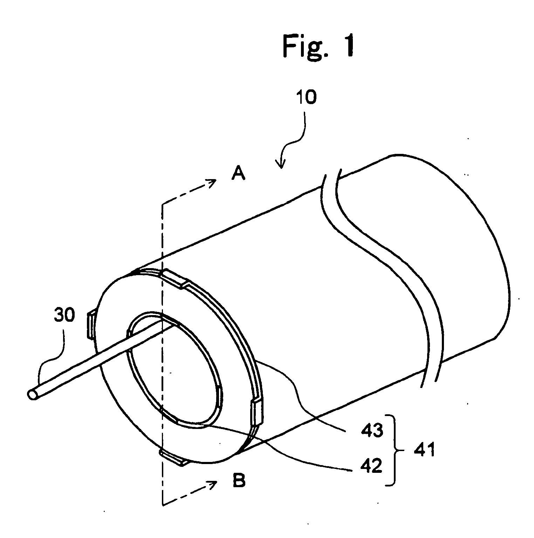

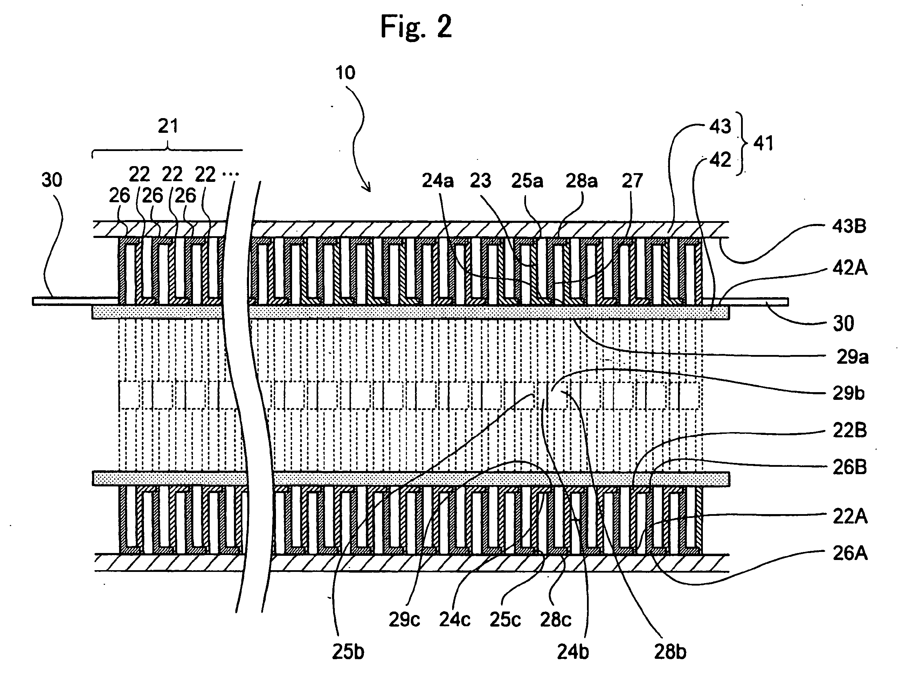

Figs. 1 and 2 show a basic structure of the present invention; Fig. 1 is a perspective view of a thermoelectric conversion module 10, and Fig. 2 is a cross-sectional view along the A-B line in the longitudinal direction of the thermoelectric conversion module 10 in Fig. 1. It is noted that some numerals are omitted in Fig. 1. As shown in these figures, the thermoelectric conversion module 10 comprises a tubular (approximately cylindrical) element unit 21 in which a disk-shaped first thermoelectric element 22 having a center hole opened and a disk-shaped second thermoelectric element 26 having a center hole opened and having approximately the same shape as the first thermoelectric element 22 (the leftmost element is the second thermoelectric element 26 in Figs. 1 and 2) are layered from the edge alternately with a predetermined space there between.

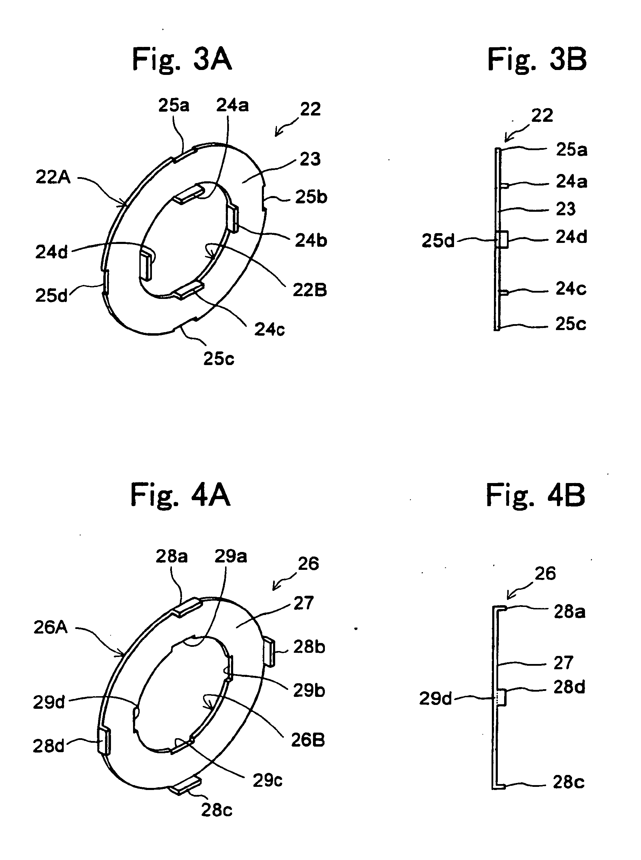

Here, the first thermoelectric element 22 and the second thermoelectric element 26 are explained with reference to Figs. 3A, 3B, 4A and 4B. Fig. 3A is a perspective view of the first thermoelectric element 22 before it is assembled in the thermoelectric conversion module 10, and Fig. 3B is a side view of the first thermoelectric element 22. Also, Fig. 4A is a perspective view of the second thermoelectric element 26 before it is assembled in the thermoelectric conversion module 10, and Fig. 4B is a side view of the second thermoelectric element 26.

As shown in Figs. 3A and 3B, on an inner circumference surface 22B of the first thermoelectric element 22 are provided two pairs of nail members 24a, 24b, 24c, 24d on the upper, lower, left and right sides extending from the inner circumference surface 22B in a direction vertical to the longitudinal direction of a first thermoelectric element main body 23, and on an outer circumference surface 22A are provided two pairs of cutouts 25a, 25b, 25c, 25d on the upper, lower, left and right sides. This first thermoelectric element 22 may be 10 mm to 100 mm in external diameter, 5 mm to 90 mm in internal diameter and 0.05 mm to 2 mm in thickness, and is preferably about 20 mm in external diameter, about 10 mm in internal diameter and about 0.1 mm in thickness.

In such a manner, the first thermoelectric element 22 only needs to include at least one first nail member such as the nail members 24a, 24b, 24c, 24d protruded from the inner circumference surface 22B and at least one first cutout such as the cutouts 25a, 25b, 25c, 25d on the outer circumference surface 22A.

On the other hand, as shown in Figs. 4A and 4B, on an outer circumference surface 26A of the second thermoelectric element 26 are provided two pairs of nail members 28a, 28b, 28c, 28d on the upper, lower, left and right sides extending from the outer circumference surface 26A in a direction vertical to the longitudinal direction of a second thermoelectric element main body 27, and on an inner circumference surface 26B are provided two pairs of cutouts 29a, 29b, 29c, 29d on the upper, lower, left and right sides. This second thermoelectric element 26 may be 10 mm to 100 mm, 5 mm to 90 mm in internal diameter and 0.05 mm to 2 mm in thickness, and is preferably about 20 mm in external diameter, about 10 mm in internal diameter and about 0.1 mm in thickness.

In such a manner, the second thermoelectric element only needs to include at least one second nail member such as the nail members 28a, 28b, 28c, 28d protruded from the outer circumference surface 26A and at least one second cutout such as the cutouts 29a, 29b, 29c, 29d on the inner circumference surface 26B.

Meanwhile, the "cutout" in the present embodiment corresponds to an example of a "receiving portion" of the present invention.

Here, the first thermoelectric element 22 is made of a silicon-aluminum-manganese-nickel alloy, and in this alloy, the component ratio of silicon is 0.5 to 2 mass%, the component ratio of aluminum is 1 to 5 mass%, the component ratio of manganese is 1 to 3 mass%, and the component ratio of nickel is 90 to 97.5 mass%, but it is preferable that the component ratio of silicon is 1 mass%, the component ratio of aluminum is 3 mass%, the component ratio of manganese is 2 mass%, and the component ratio of nickel is 94 mass%.

On the other hand, the second thermoelectric element 26 is made of a nickel alloy selected from a group consisting of a chromium-nickel alloy and a chromium-iron-nickel alloy. When the second thermoelectric element 26 is a chromium-nickel alloy, the component ratio of chromium may be 5 to 25 mass%, and the component ratio of nickel may be 75 to 95 mass% in this alloy, and it is preferable that the component ratio of chromium is about 10 mass%, and the component ratio of nickel is about 90 mass%. Also, when the second thermoelectric element 26 is a chromium-iron-nickel alloy, the component ratio of chromium may be 5 to 10 mass%, the component ratio of iron may be 20 to 30 mass%, and the component ratio of nickel may be 60 to 75 mass%, and it is preferable that the component ratio of chromium is about 10 mass%, the component ratio of iron is about 25 mass%, and the component ratio of nickel is about 65 mass%.

Accordingly, since the thermoelectric conversion module 10 uses nickel alloys as materials for the thermoelectric elements, the manufacturing cost of the thermoelectric conversion module can be reduced without degrading the thermoelectric conversion performance, in comparison with that of a conventional thermoelectric conversion module using thermoelectric elements made of BiTe alloys. Further, since the nickel alloys have superior mechanical strength and stability under a high temperature to those of the BiTe alloys, the thermoelectric conversion module 10 has greater processability and provides more stable use under a high temperature than the thermoelectric conversion module using thermoelectric elements made of BiTe alloys does.

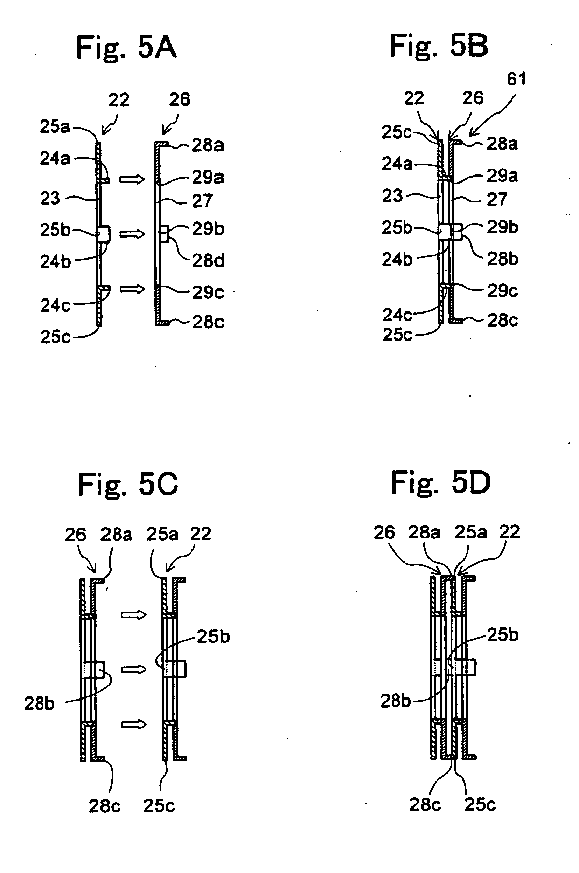

Also, as described above, the first thermoelectric element 22 and the second thermoelectric element 26 are layered alternately to form the tubular element unit 21. Here, the state in which "the first thermoelectric element 22 and the second thermoelectric element 26 are layered alternately" is explained with reference to Fig. 5. Fig. 5A is a cross-sectional view before the nail members 24a to 24d of the first thermoelectric element 22 are engaged with the cutouts 29a to 29d on the inner circumference surface 26B of the second thermoelectric element 26, Fig. 5B is a cross-sectional view of a ring-shaped pi-type element 61 formed after the nail members 24a to 24d of the first thermoelectric element 22 have been engaged with the cutouts 29a to 29d on the inner circumference surface 26B of the second thermoelectric element 26, Fig. 5C is a cross-sectional view before the two ring-shaped pi-type elements 61 are connected to each other, and Fig. 5D is a cross-sectional view of the two ring-shaped pi-type elements 61 after they have been connected. It is noted that some numerals are omitted in Figs. 5C and 5D.

As shown in Figs. 5A and 5B, the nail members 24a, 24b, 24c, 24d provided on the inner circumference surface 22B of the first thermoelectric element 22 are engaged with and then welded to the cutouts 29a, 29b, 29c, 29d on the inner circumference surface 26B of the second thermoelectric element 26, respectively. That is, the nail members 24a to 24d provided on the inner circumference surface 22B of the first thermoelectric element 22 are connected to the inner circumference surface 26B of the second thermoelectric element 26. Also, as shown in Figs. 5C and 5D, the nail members 28a, 28b, 28c, 28d provided on the outer circumference surface 26A of the second thermoelectric element 26 are engaged with the cutouts 25a, 25b, 25c, 25d on the outer circumference surface 22A of the first thermoelectric element 22, respectively. That is, the nail members 28a to 28d provided on the outer circumference surface 26A of the second thermoelectric element 26 are connected to the outer circumference surface 22A of the first thermoelectric element 22. In the above manner, the first nail member is engaged with the second cutout, and the second nail member is engaged with the first cutout.

In such a manner, the nail members 24a to 24d provided on the inner circumference surface 22B of the first thermoelectric element 22 are engaged with the cutouts 29a to 29d on the inner circumference surface 26B of the second thermoelectric element 26, respectively, and the nail members 28a to 28d provided on the outer circumference surface 26A of the second thermoelectric element 26 are engaged with the cutouts 25a to 25d on the outer circumference surface 22A of the first thermoelectric element 22, respectively. Thus, the thermoelectric conversion module 10 needs only a small number of parts since it does not require an electrode that electrically connects thermoelectric elements to each other as in the conventional thermoelectric conversion module.

Returning to Figs. 1 and 2, let us continue to explain the thermoelectric conversion module 10. The first thermoelectric element 22 and the second thermoelectric element 26 located on both edges of the element unit 21 are connected to a lead wire 30 as an external connection wire. The lead wire 30 is preferably a metal such as gold, silver, etc. having lower electric resistance than that of the first thermoelectric element 22 and the second thermoelectric element 26.

Also, the element unit 21 is supported by a coaxial support unit 41 consisting of a SUS tube 42 whose outer circumference surface 42A has been insulated and a SUS tube 43 whose inner circumference surface 43B has been insulated. That is, the SUS tube 42 internally touches the element unit 21, and the SUS tube 43 externally touches the element unit 21. That is to say, an outer tube whose outer circumference surface has been insulated is fitted in the center hole of the element unit, and an inner tube whose inner circumference surface has been insulated is fitted on the outer circumference surface of the element unit.

Accordingly, the thermoelectric conversion module 10 comprises the element unit 21 in which the first thermoelectric element 22 and the second thermoelectric element 26 are layered alternately and the support unit 41 consisting of the SUS tube 42 that internally touches this element unit 21 and the SUS tube 43 that externally touches the element unit 21. Thus, the thermoelectric conversion module 10 can be assembled more easily than the conventional thermoelectric conversion module since it has a simple structure in which the element unit 21 is formed by layering the first thermoelectric element 22 and the second thermoelectric element 26 alternately, and in which this element unit 21 is just supported by the SUS tube 42 and the SUS tube 43.

Also, in the present invention, tubes made of other materials may be used as long as they can support the element unit 21 and have excellent heat conductivity.

Further, in the present embodiment, the "SUS tube 42" corresponds to an example of an "inner tube" of the present invention, and the "SUS tube 43" corresponds to an example of an "outer tube" of the present invention.

When the element unit 21 adopting the above structure is heated or cooled from the SUS tube 43 side or the SUS tube 42 side, electromotive force is generated by the temperature difference between the inner circumference surface 22B and the outer circumference surface 22A of the first thermoelectric element 22 and the temperature difference between the inner circumference surface 26B and the outer circumference surface 26A of the second thermoelectric element 26. The generated electromotive force is supplied to the external load through the lead wire 30 that is an electrode.

### [Embodiment]

### <Preparation of the first thermoelectric element and the second thermoelectric element>

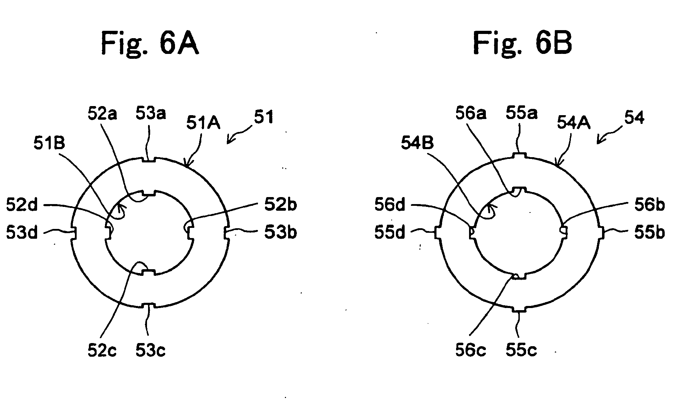

Preparation of the first thermoelectric element and the second thermoelectric element will be described with reference to Figs. 3A, 4A, 6A and 6B. Fig. 6A is a front view showing a first nickel alloy plate 51 formed by punching out a plate foil of a silicon-aluminum-manganese-nickel alloy, and Fig. 6B is a front view showing a second nickel alloy plate 54 formed by punching out a plate foil of a chromium-nickel alloy. Meanwhile, as for the component ratio of each metal in the silicon-aluminum-manganese-nickel alloy, that of silicon is 1 mass%, that of aluminum is 3 mass%, that of manganese is 2 mass%, and that of nickel is 94 mass%, and as for the component ratio of each metal in the chromium-nickel alloy, that of chromium is 10 mass%, and that of nickel is 90 mass%.

Firstly, a thousand silicon-aluminum-manganese-nickel alloy plate foils each having a thickness of 0.1 mm and a thousand chromium-nickel alloy plate foils having a thickness of 0.1 mm were punched out in a disk shape to prepare the first nickel alloy plates 51 and the second nickel alloy plates 54. As shown in Fig. 6A, on an inner circumference surface 51B of the first nickel alloy plate 51 are provided two pairs of protruded pieces 52a, 52b, 52c, 52d on the upper, lower, left and right sides, and on an outer circumference surface 51A are provided two pairs of cutouts 53a, 53b, 53c, 53d on the upper, lower, left and right sides. Also, as shown in Fig. 6B, on an outer circumference surface 54A of the second nickel alloy plate 54 are provided two pairs of protruded pieces 55a, 55b, 55c, 55d on the upper, lower, left and right sides, and on an inner circumference surface 54B are provided two pairs of cutouts 56a, 56b, 56c, 56d on the upper, lower, left and right sides. Then, the four protruded pieces 52a to 52d on the inner circumference surface 51B of the punched-out first nickel alloy plate 51 were folded vertically to the longitudinal direction of the first nickel alloy plate 51 to prepare the first thermoelectric element 22 having the nail members 24a to 24d on the inner circumference surface 22B and having the cutouts 25A to 25d on the outer circumference surface 22A (refer to Fig. 3A). Also, in the same manner, the four protruded pieces 55a to 55d on the outer circumference surface 54A of the punched-out second nickel alloy plate 54 were folded vertically to the longitudinal direction of the second nickel alloy plate 54 to prepare the second thermoelectric element 26 having the nail members 28a to 28d on the outer circumference surface 26A and having the cutouts 29A to 29d on the inner circumference surface 26B (refer to Fig. 4A). Meanwhile, both the first nickel alloy plate 51 and the second nickel alloy plate 54 are 20 mm in external diameter, 10 mm in internal diameter and 0.1 mm in thickness.

### <Preparation of the thermoelectric conversion module>

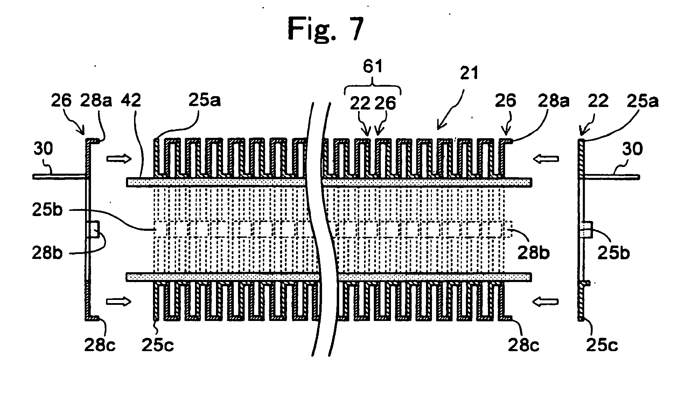

Preparation of the thermoelectric conversion module will be described with reference to Figs. 2, 5A to 5D and 7. Fig. 7 is a cross-sectional view of the element unit 21 in which 999 pairs of ring-shaped pi-type elements 61 have been connected. It is noted that some numerals are omitted in Fig. 7.

As shown in Figs. 5A and 5B, the nail members 24a to 24d on the inner circumference surface 22B of the first thermoelectric element 22 were engaged with and then welded to the cutouts 29a to 29d on the inner circumference surface 26B of the second thermoelectric element 26 to prepare the ring-shaped pi-type element 61 shown in Fig. 5B. Then, as shown in Figs. 5C and 5D, the procedure in which the cutouts 25a to 25d on the outer circumference surface 22A of the first thermoelectric element 22 constituting one ring-shaped pi-type element 61 are engaged with the nail members 28a to 28d on the outer circumference surface 26A of the second thermoelectric element 26 constituting another ring-shaped pi-type element 61 was sequentially performed to prepare the element unit 21 having 999 pairs of ring-shaped pi-type elements 61. This element unit 21 was inserted on the SUS tube 42 having an external diameter of 10 mm, an internal diameter of 8 mm and a length of 300 mm (refer to Fig. 7). Next, the cutouts 25a to 25d of the first thermoelectric element 22 on one edge of the element unit 21 were engaged with the nail members 28a to 28d of the second thermoelectric element 26 electrically connected to the lead wire 30. Also, the cutouts 25a to 25d of the first thermoelectric element 22 electrically connected to the lead wire 30 were engaged with the nail members 28a to 28d of the second thermoelectric element 26 on the other edge of the element unit 21. Further, the element unit 21 was supported by the SUS tube 43 having an external diameter of 22 mm, an internal diameter of 20 mm and a length of 300 mm to obtain the thermoelectric conversion module 10 having 1000 pairs of ring-shaped pi-type elements 61 (refer to Fig. 2).

### <Evaluation of electric generating characteristics>

The thermoelectric conversion module 10 having 1000 pairs of ring-shaped pi-type elements 61 was set in a small tubular furnace having a 250 mm soaking area and was heated at a temperature of 450 degrees C. Water was applied in the SUS tube 42 that is an inner tube to cool it. When the temperature difference between the SUS tube 43 that is an outer tube and the SUS tube 42 that is an inner tube was 400 degrees C, 14V open-circuit voltage and 46W maximum output were obtained.

### [Other embodiments]

Meanwhile, although the shape of the first thermoelectric element 22 and the second thermoelectric element 26 is a disk shape having a hole opened at the center in the present embodiment, any shape of the thermoelectric element may be applicable in the present invention as long as it has a hole in which the SUS tube 42 that is an inner tube is to be inserted (fitted), and it may be, for example, a rectangular shape, etc.

Also, although the cutouts 25a to 25d are provided on the outer circumference surface 22A of the first thermoelectric element 22, and the cutouts 29a to 29d are provided on the inner circumference surface 26B of the second thermoelectric element 26 in the present embodiment, these cutouts may be in any shape in the present invention as long as they have a function as a receiving portion that is to be engaged with the nail member or a function as a receiving portion to which the nail member is to be welded.

Also, although the nickel alloys have been used as materials for the disk-shaped thermoelectric elements in the present embodiment, the present invention is not limited to them, but any material may be used as a material for the disk-shaped thermoelectric element according to the present invention as long as it enables electric generation by the temperature difference between the inner circumference surface and the outer circumference surface, enables more material cost reduction, is easier to process, has more stability under a high temperature, and is a more environment-friendly material than the BiTe alloy.

Also, although two pairs of nail members 24a, 24b, 24c, 24d on the upper, lower, left and right sides extending from the inner circumference surface 22B in a direction vertical to the longitudinal direction of the first thermoelectric element main body 23 are provided on the inner circumference surface 22B of the first thermoelectric element 22, and two pairs of cutouts 25a, 25b, 25c, 25d on the upper, lower, left and right sides are provided on the outer circumference surface 22A in the present embodiment, the present invention is not limited to this case. That is, at least one nail member that is to be engaged with the inner circumference surface 26B of the second thermoelectric element 26 only needs to be provided on the inner circumference surface 22B of the first thermoelectric element 22, and also, at least one receiving portion that is to be engaged with the nail member on the outer circumference surface 26A of the second thermoelectric element 26 only needs to be provided on the outer circumference surface 22A of the first thermoelectric element 22.

Further, although two pairs of nail members 28a, 28b, 28c, 28d on the upper, lower, left and right sides extending from the outer circumference surface 26A in a direction vertical to the longitudinal direction of the second thermoelectric element main body 27 are provided on the outer circumference surface 26A of the second thermoelectric element 26, and two pairs of cutouts 29a, 29b, 29c, 29d on the upper, lower, left and right sides are provided on the inner circumference surface 26B in the present embodiment, the present invention is not limited to this case. That is, at least one nail member that is to be connected to the outer circumference surface 22A of the first thermoelectric element 22 only needs to be provided on the outer circumference surface 26A of the second thermoelectric element 26, and also, at least one receiving portion that is to be connected to the nail member on the inner circumference surface 22B of the first thermoelectric element 22 only needs to be provided on the inner circumference surface 26B of the second thermoelectric element 26.

Also, although the first thermoelectric element 22 is made of a silicon-aluminum-manganese-nickel alloy, and the second thermoelectric element 26 is made of a nickel alloy selected from a group consisting of a chromium-nickel alloy and a chromium-iron-nickel alloy in the present embodiment, the second thermoelectric element 26 may be made of a silicon-aluminum-manganese-nickel alloy, and the first thermoelectric element 22 may be made of a nickel alloy selected from a group consisting of a chromium-nickel alloy and a chromium-iron-nickel alloy.

Also, although the nail members 24a, 24b, 24c, 24d of the first thermoelectric element 22 are engaged with and then welded to the cutouts 29a, 29b, 29c, 29d of the second thermoelectric element 26, respectively, and the nail members 28a, 28b, 28c, 28d of the second thermoelectric element 26 are engaged with the cutouts 25a, 25b, 25c, 25d of the first thermoelectric element 22, respectively, in the present embodiment, the present invention is not limited to this case, but at least one nail member only needs to be engaged with and then welded to at least one cutout, and at least one nail member only needs to be engaged with at least one cutout.

Also, in the present invention, the number of the ring-shaped pi-type elements (or the pairs each consisting of a disk-shaped first thermoelectric element having a center hole opened and a disk-shaped second thermoelectric element having a center hole opened and having approximately the same shape) included in the thermoelectric conversion module may be determined arbitrarily in consideration of desired voltage, temperature difference between the inner circumference surface and the outer circumference surface, etc. For example, in a case where higher voltage is desired, the number may be increased (i.e., the length of the thermoelectric conversion module is extended), and in a case where preferable temperature difference cannot be maintained in the longitudinal direction, the number may be decreased to shorten the length of the thermoelectric conversion module. When various kinds of factors like these are considered, it is assumed that 500 to 2000 pieces will substantially be preferable as the number of the ring-shaped pi-type elements:

## Claims

1. A thermoelectric conversion module (10) comprising:
a tubular element unit (21) in which a disk-shaped first thermoelectric element (22) and a disk-shaped second thermoelectric element (26) that generate electricity by temperature difference between an inner circumference surface (22B, 26B) and an outer circumference surface (22A, 26A) are layered alternately; and
a support unit (41) consisting of an electrically insulated inner tube (42) that internally touches said element unit (21) and an electrically insulated outer tube (43) that externally touches said element unit (21), **characterised in that**
on the inner circumference surface (22B) of said first thermoelectric element (22) is provided a nail member (24a, 24b, 24c, 24d) that is to be connected to the inner circumference surface (26B) of said second thermoelectric element (26), and
wherein on the outer circumference surface (26A) of said second thermoelectric element (26) is provided a nail member (28a, 28b, 28c, 28d) that is to be connected to the outer circumference surface (22A) of said first thermoelectric element (22).

2. The thermoelectric conversion module (10) according to claim 1, wherein on the outer circumference surface (22A) of said first thermoelectric element (22) is provided a receiving portion (25a, 25b, 25c, 25d) to which said nail member (28a, 28b, 28c, 28d) of said second thermoelectric element (26) is to be connected, and
wherein on the inner circumference surface (26B) of said second thermoelectric element (26) is provided a receiving portion (29a, 29b, 29c, 29d) to which said nail member (24a, 24b, 24c, 24d) of said first thermoelectric element (22) is to be connected.

3. The thermoelectric conversion module (10) according to claim 2, wherein said nail member (24a, 24b, 24c, 24d, 28a, 28b, 28c, 28d) is engaged with said receiving portion (25a, 25b, 25c, 25d, 29a, 29b, 29c, 29d).

4. The thermoelectric conversion module (10) according to claim 2, wherein said nail member (24a, 24b, 24c, 24d, 28a, 28b, 28c, 28d) is welded to said receiving portion (25a, 25b, 25c, 25d, 29a, 29b, 29c, 29d).

5. The thermoelectric conversion module (10) according to any one of claims 1 to 4, wherein said first thermoelectric element (22) is made of a silicon-aluminum-manganese-nickel alloy, and
wherein said second thermoelectric element (26) is made of a nickel alloy selected from a group consisting of a chromium-nickel alloy and a chromium-iron-nickel alloy.

6. The thermoelectric conversion module (10) according to any one of claims 1 to 4, wherein said second thermoelectric element (26) is made of a silicon-aluminum-manganese-nickel alloy, and
wherein said first thermoelectric element (22) is made of a nickel alloy selected from a group consisting of a chromium-nickel alloy and a chromium-iron-nickel alloy.

## Patentansprüche

1. Thermoelektrisches Umwandlungsmodul (10) mit:
einer röhrenförmigen Elementeinheit (21), in die ein scheibenförmiges erstes thermoelektrisches Element (22) und ein scheibenförmiges zweites thermoelektrisches Element (26) abwechselnd geschichtet sind, die elektrischen Strom durch einen Temperaturunterschied zwischen einer Oberfläche eines inneren Umfangs (22B, 26B) und einer Oberfläche eines äußeren Umfangs (22A, 26A) erzeugen; und
einer Auflageeinheit (41) bestehend aus einer elektrisch isolierten inneren Röhre (42), welche die Elementeinheit (21) innen berührt, und einer elektrisch isolierten äußeren Röhre (43), welche die Elementeinheit (21) außen berührt, **dadurch gekennzeichnet, dass**
an der Oberfläche des inneren Umfangs (22B) des ersten thermoelektrischen Elements (22) ein Stiftglied (24a, 24b, 24c, 24d) zum Verbinden mit der Oberfläche des inneren Umfangs (26B) des zweiten thermoelektrischen Elements (26) vorgesehen ist und
wobei an der Oberfläche des äußeren Umfangs (26A) des zweiten thermoelektrischen Elements (26) ein Stiftglied (28a, 28b, 28c, 28d) zum Verbinden mit der Oberfläche des äußeren Umfangs (22A) des ersten thermoelektrischen Elements (22) vorgesehen ist.

2. Thermoelektrisches Umwandlungsmodul (10) nach Anspruch 1, bei dem an der Oberfläche des äußeren Umfangs (22A) des ersten thermoelektrischen Elements (22) ein Aufnahmeabschnitt (25a, 25b, 25c, 25d) vorgesehen ist, mit dem das Stiftglied (28a, 28b, 28c, 28d) des zweiten thermoelektrischen Elements (26) verbindbar ist, und
bei dem an der Oberfläche des inneren Umfangs (26B) des zweiten thermoelektrischen Elements (26) ein Aufnahmeabschnitt (29a, 29b, 29c, 29d) vorgesehen ist, mit dem das Stiftglied (24a, 24b, 24c, 24d) des ersten thermoelektrischen Elements (22) verbindbar ist.

3. Thermoelektrisches Umwandlungsmodul (10) nach Anspruch 2, bei dem das Stiftglied (24a, 24b, 24c, 24d, 28a, 28b, 28c, 28d) in Eingriff mit dem Aufnahmeabschnitt (25a, 25b, 25c, 25d, 29a, 29b, 29c, 29d) ist.

4. Thermoelektrisches Umwandlungsmodul (10) nach Anspruch 2, bei dem das Stiftglied (24a, 24b, 24c, 24d, 28a, 28b, 28c, 28d) an den Aufnahmeabschnitt (25a, 25b, 25c, 25d, 29a, 29b, 29c, 29d) angeschweißt ist.

5. Thermoelektrisches Umwandlungsmodul (10) nach einem der Ansprüche 1 bis 4, bei dem das erste thermoelektrische Element (22) aus einer Silizium-Aluminium-Mangan-Nickel-Legierung besteht und
bei dem das zweite thermoelektrische Element (26) aus einer Nickel-Legierung ausgewählt aus einer Gruppe bestehend aus einer Chrom-Nickel-Legierung und einer Chrom-Eisen-Nickel-Legierung besteht.

6. Thermoelektrisches Umwandlungsmodul (10) nach einem der Ansprüche 1 bis 4, bei dem das zweite thermoelektrische Element (26) aus einer Silizium-Aluminium-Mangan-Nickel-Legierung besteht und
bei dem das erste thermoelektrische Element (22) aus einer Nickel-Legierung ausgewählt aus einer Gruppe bestehend aus einer Chrom-Nickel-Legierung und einer Chrom-Eisen-Nickel-Legierung besteht.

## Revendications

1. Module de conversion thermoélectrique (10) comprenant :
une unité formant élément tubulaire (21) dans laquelle un premier élément thermoélectrique en forme de disque (22) et un second élément thermoélectrique en forme de disque (26) qui génère de l'électricité par différence de température entre une surface de circonférence intérieure (22B, 26B) et une surface de circonférence extérieure (22A, 26A) sont disposés en couche en alternance ; et
une unité de support (41) consistant en un tube intérieur électriquement isolé (42) qui touche en interne ladite unité formant élément (21) et en un tube extérieur électriquement isolé (43) qui touche en externe ladite unité formant élément (21), **caractérisé en ce que**
sur la surface de circonférence intérieure (22B) dudit premier élément thermoélectrique (22) est disposé un élément à crampons (24a, 24b, 24c, 24d) qui doit être relié à la surface de circonférence intérieure (26B) dudit second élément thermoélectrique (26), et
dans lequel, sur la surface de circonférence extérieure (26A) dudit second élément thermoélectrique (26) est disposé un élément à crampons (28a, 28b, 28c, 28d) qui doit être relié à la surface de circonférence extérieure (22A) dudit premier élément thermoélectrique (22).

2. Module de conversion thermoélectrique (10) selon la revendication 1, dans lequel, sur la surface de circonférence extérieure (22A) dudit premier élément thermoélectrique (22), est disposée une partie réceptrice (25a, 25b, 25c, 25d) à laquelle ledit élément à crampons (28a, 28b, 28c, 28d) dudit second élément thermoélectrique (26) doit être relié, et
dans lequel sur la surface de circonférence intérieure (26B) dudit second élément thermoélectrique (26) est disposée une partie réceptrice (29a, 29b, 29c, 29d) à laquelle ledit élément à crampons (24a, 24b, 24c, 24d) dudit premier élément thermoélectrique (22) doit être relié.

3. Module de conversion thermoélectrique (10) selon la revendication 2, dans lequel ledit élément à crampons (24a, 24b, 24c, 24d, 28a, 28b, 28c, 28d) est en prise avec ladite partie réceptrice (25a, 25b, 25c, 25d, 29a, 29b, 29c, 29d).

4. Module de conversion thermoélectrique (10) selon la revendication 2, dans lequel ledit élément à crampons (24a, 24b, 24c, 24d, 28a, 28b, 28c, 28d) est soudé à ladite partie réceptrice (25a, 25b, 25c, 25d, 29a, 29b, 29c, 29d).

5. Module de conversion thermoélectrique (10) selon l'une quelconque des revendications 1 à 4, dans lequel ledit premier élément thermoélectrique (22) est fait d'un alliage de silicium-aluminium-manganèse-nickel, et
dans lequel ledit second élément thermoélectrique (26) est fait d'un alliage de nickel sélectionné à partir d'un groupe consistant en un alliage de chrome-nickel et en un alliage de chrome-fer-nickel.

6. Module de conversion thermoélectrique (10) selon l'une quelconque des revendications 1 à 4, dans lequel ledit second élément thermoélectrique (26) est fait d'un alliage de silicium-aluminium-manganèse-nickel, et
dans lequel ledit premier élément thermoélectrique (22) est fait d'un alliage de nickel sélectionné à partir d'un groupe consistant en un alliage de chrome-nickel et un alliage de chrome-fer-nickel.
